# EUROPEAN PATENT APPLICATION

(11) **EP 2 405 472 A2**
(43) Date of publication of application: **11.01.2012**
(21) Application number: 11173343.2
(22) Date of filing: 08.07.2011
(51) Int. Cl.: H01L 21/48, H01L 21/50, H01L 23/055

(54) **Method of Manufacturing Glass Substrate and Method of Manufacturing Electronic Components**

(30) Priority: 08.07.2010 JP 2010156172
(71) Applicant: Seiko Instruments Inc., Chiba-shi, Chiba (JP)
(72) Inventor: Terao, Eiji, Chiba (JP)
(74) Representative: Cloughley, Peter Andrew

(57) **Abstract**

Disclosed is a method of manufacturing a glass substrate with through electrodes, the method including: a wire stretching process in which a plurality of conductive wires are stretched in parallel between upper and lower bases; a wire burying process in which a plurality of the wires between the bases are buried by glass; an ingot formation process in which a glass ingot having the buried wires is formed by cooling the glass; a slicing process in which a glass panel is formed by slicing the glass ingot; and a polishing process in which a plurality of the wires are exposed on front and rear surfaces of the glass panel to provide the through electrodes.

## Description

The invention relates to a method of manufacturing a plurality of through electrodes in a substrate and a method of manufacturing electronic components using the same.

In recent years, piezoelectric vibrators using crystals or the like have been used in a clock source or a timing source of mobile phones or mobile information devices. Various piezoelectric vibrators are known in the art, and a surface-mounted type piezoelectric vibrator is known as one. In addition, a three-layered structure as the piezoelectric vibrator is known in the art, in which a piezoelectric substrate, where a piezoelectric vibrating reed is formed, is vertically interposed and bonded between a base substrate and a lid substrate. The piezoelectric vibrating reed is housed in a cavity formed between the base substrate and the lid substrate.

Furthermore, recently, a two-layered structure piezoelectric vibrator has been developed. This type is formed from a two-layered structure package obtained by directly bonding the base substrate and the lid substrate, and the piezoelectric vibrating reed is housed in the cavity between the base substrate and the lid substrate. The two-layered structure piezoelectric element is advantageous in that it can allow for a lower profile compared to the three-layered structure piezoelectric element.

JP-A-2002-124845 and JP-A-2002-121037 disclose a two-layered structure crystal vibrator package in which a glass material is used as a package material for the base substrate or the lid substrate. The glass material facilitates shaping and reduces manufacturing costs compared to ceramics. In addition, since the glass material has a low thermal conductivity, it provides an excellent thermal insulation property, so as to protect an internal piezoelectric vibrator from temperature variation.

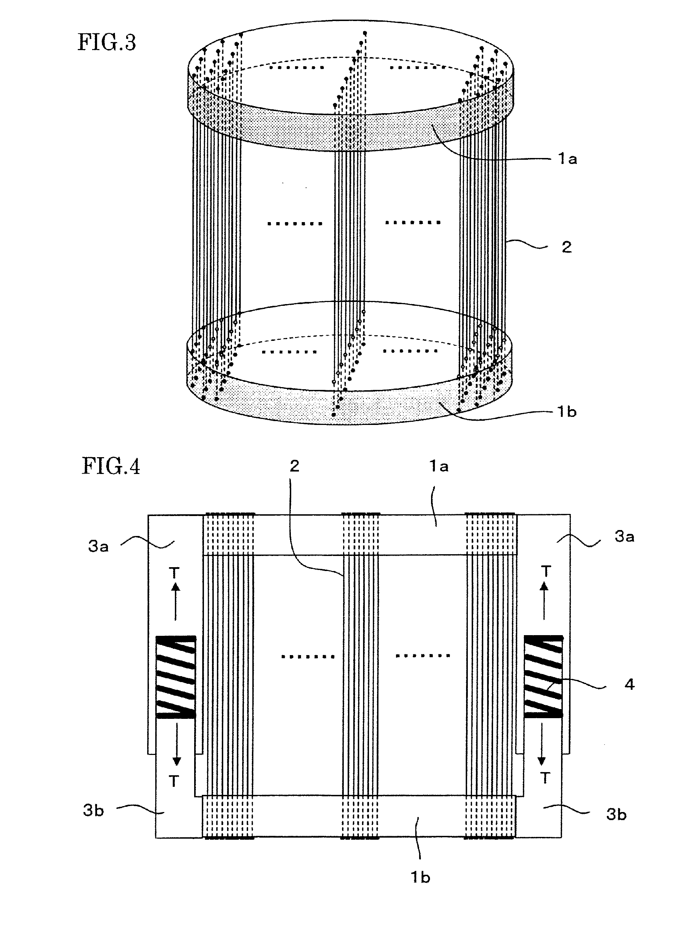

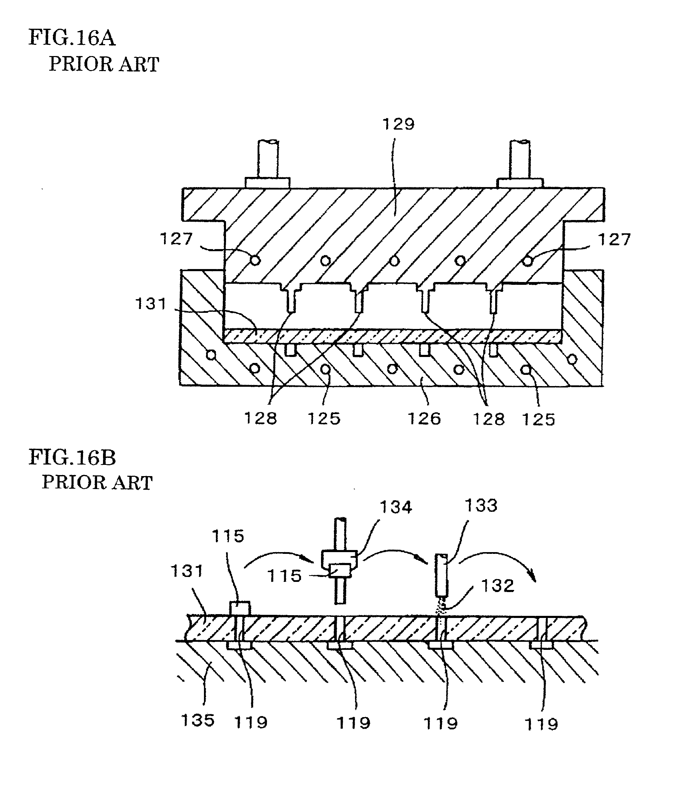

JP-A-2003-209198 discloses another two-layered structure crystal vibrator package similar to the aforementioned one. In this case, a glass material is also used in the base substrate, and a method of forming through electrodes using a metal material in the base substrate is disclosed. When the through electrodes are formed in the glass material, first, via-holes are formed in the glass panel. Figs. 16A and 16B illustrate a method of forming through electrodes including a metal pin 115 in the glass panel 131 (Fig. 3 of JP-A-2003-209198). Fig. 16A illustrates a method of forming a via-hole 119 in the glass panel 131. The glass panel 131 is provided at the bottom of the die 126. The die 126 is provided with a heater 125 so as to heat the glass panel 131. In the upper portion of the die 126, a punch press including a punch 129 is provided. In the glass panel 131 side of the punch 129, perforating pins 128 are provided, and the heater 127 is also provided in the punch 129. In addition, after heating the glass panel 131 to a predetermined temperature, the punch 129 is pressed down to form the via-hole 119.

Fig. 16B illustrates a method of implanting a metal pin 115 in the via-hole 119 of the glass panel 131. The glass panel 131 where the via-hole 119 has been formed is installed in the die 135, and the glass frit 132 is blown into the via-hole 119 using a glass frit blower 133. Then, the metal pin 115 is implanted into the via-hole 119 using a metal pin punch 134.

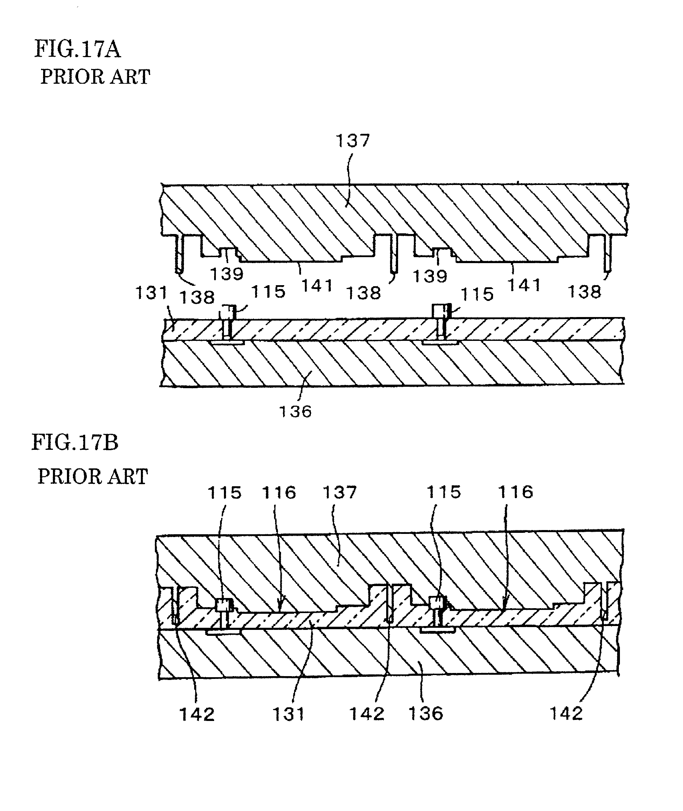

Figs. 17A and 17B illustrate a press-molding process (Fig. 4 of JP-A-2003-209198). As shown in Fig. 17A, the glass panel 131 having the metal pin 115 implanted into the via-hole 119 is interposed between the lower press template 136 and the upper press template 137. The upper press template 137 is provided with a partitioning convex ridge 138, a pin head hosting recess 139, or a recess-forming convex ridge 141. These templates are placed into an electric furnace and heated to a temperature of 1000°C or higher while the upper and lower press templates 137 and 136 are pressed to each other. As a result, as shown in Fig. 17B, the engraving on the surface of the upper press template 137 is transferred to the glass panel 131 so that a partitioning trench 142 or a recess 116 is formed in the glass panel 131. At the same time, through electrodes including the metal pin 115 having a hermetical sealing property are formed in the glass panel 131.

However, if the glass panel 131 is heated, the via-hole 119 is formed, and then, the glass panel 131 is cooled, the glass panel 131 is distorted due to internal stress, and the flatness of the glass panel 131 is degraded. In addition, if the cooling is performed after the surface engraving of the upper press template 137 is transferred to the glass panel 131, some problems may occur. For example, the metal pin 115 may be slanted, or positioning of the metal pin 115 may be deviated due to floating of glass during the transfer or irregular heat distribution during the cooling. In addition, the glass panel 131 may be complexly distorted due to internal stress. If the bending is to be corrected through grinding, the amount of grinding may become significant, and much time may be necessary in the fabrication. In addition, the number of parts having a predetermined shape may be reduced. Furthermore, the metal pin 115 exposed on the bottom of the recess 116 is slanted, so that the positions of the through electrodes may be deviated. If the flatness of the top surface of the side wall surrounding the recess 116 is not excellent, the hermetical sealing property of the lid joining with the top surface may not be guaranteed. This may reduce reliability of an electronic component.

The invention has been made to address the aforementioned problems, and provides a glass substrate having excellent flatness with through electrodes provided with a high positioning precision.

According to an aspect of the invention, there is provided a method of manufacturing a glass substrate with through electrodes, the method including: a wire stretching process in which a plurality of conductive wires are stretched in parallel between two bases; a wire burying process in which a plurality of the wires between the bases are buried by glass; an ingot formation process in which a glass ingot having the buried wires is formed by cooling the glass; a slicing process in which a glass panel is formed by slicing the ingot; and a polishing process in which a plurality of the wires are exposed on front and rear surfaces by polishing the glass panel to provide the through electrode.

In addition, it is preferable that the wire stretching process includes a via-hole formation process in which a plurality of via-holes are formed in the two bases, a wire installation process in which a plurality of the wires are penetrated through a plurality of via-holes, a securing section formation process in which a securing section for securing one end of the wire in the base is formed, and a tensioning process in which the wires are tensioned.

In addition, it is preferable that, in the ingot formation process, a cooling rate from a temperature 50°C higher than the distortion point of the glass substrate to a temperature 50°C lower than the distortion point thereof is configured to be slower than a cooling rate to a temperature 50°C higher than the distortion point thereof.

In addition, it is preferable that a thermal expansion coefficient of the wire is substantially equal to that of the glass.

According to another aspect of the invention, there is provided a method of manufacturing an electronic component, the method including: a base substrate formation process in which the glass substrate is formed based on any one of the methods of manufacturing the glass substrate with through electrodes described above, and an electrode is formed in the glass substrate to provide a base substrate; a mounting process in which an electronic component is mounted on the base substrate; and a bonding process in which a lid substrate is bonded to the base substrate having the mounted electronic component.

The method of manufacturing a glass substrate with through electrodes according to the invention includes: a wire stretching process in which a plurality of conductive wires are stretched in parallel between two bases; a wire burying process in which a plurality of the wires between the bases are buried by glass; an ingot formation process in which a glass ingot having the buried wires is formed by cooling the glass; a slicing process in which a glass panel is formed by slicing the ingot; and a polishing process in which a plurality of the wires are exposed on front and rear surfaces by polishing the glass panel to provide the through electrode. As a result, it is possible to control positions of the wires with high precision. In addition, since the glass ingot is sliced after cooling, it is possible to form the glass substrate with through electrodes having a high hermetical sealing property without bending.

Embodiments of the present invention will now be described by way of further example only and with reference to the accompanying drawings, in which:
Fig. 1 is a flowchart illustrating a method of manufacturing a glass substrate with through electrodes according to an embodiment of the invention.
Fig. 2 is a flowchart illustrating a method of manufacturing a glass substrate with through electrodes according to an embodiment of the invention.
Fig. 3 illustrates a method of manufacturing a glass substrate with through electrodes according to an embodiment of the invention showing a condition in which wires are installed between upper and lower bases.
Fig. 4 illustrates a method of manufacturing a glass substrate with through electrodes according to an embodiment of the invention showing a condition in which wires are tensioned.
Fig. 5 illustrates a method of manufacturing a glass substrate with through electrodes according to an embodiment of the invention showing a condition in which the upper and lower bases having wires installed are placed into a container.
Fig. 6 illustrates a method of manufacturing a glass substrate with through electrodes according to an embodiment of the invention showing a condition in which a glass ingot is cut into round slices.
Figs. 7A and 7B illustrate a method of manufacturing a glass substrate with through electrodes according to an embodiment of the invention, showing a glass substrate.
Fig. 8 illustrates a method of manufacturing a glass substrate with through electrodes according to an embodiment of the invention showing a condition in which a via-hole is formed in the base.
Fig. 9 illustrates a method of manufacturing a glass substrate with through electrodes according to an embodiment of the invention showing a condition in which wires are installed in the base.
Fig. 10 illustrates a method of manufacturing a glass substrate with through electrodes according to an embodiment of the invention showing a condition in which a locking section is formed in the wires.
Fig. 11 illustrates a method of manufacturing a glass substrate with through electrodes according to an embodiment of the invention showing a condition in which the wires are tensioned.
Fig. 12 is a flowchart illustrating a method of manufacturing an electronic component according to an embodiment of the invention.
Fig. 13 illustrates a method of manufacturing an electronic component according to an embodiment of the invention showing a condition in which a piezoelectric vibrating reed is mounted on a glass substrate.
Fig. 14 illustrates a method of manufacturing an electronic component according to an embodiment of the invention showing a cross-sectional view of a piezoelectric vibrator.
Fig. 15 is a schematic top view illustrating an oscillator including a piezoelectric vibrator manufactured using a method of manufacturing an electronic component according to an embodiment of the invention.
Figs. 16A and 16B illustrate a method of forming via-holes in a glass panel and implanting pins in the related art.
Figs. 17A and 17B illustrate a condition in which a glass panel is molded using a press-molding method in the related art.

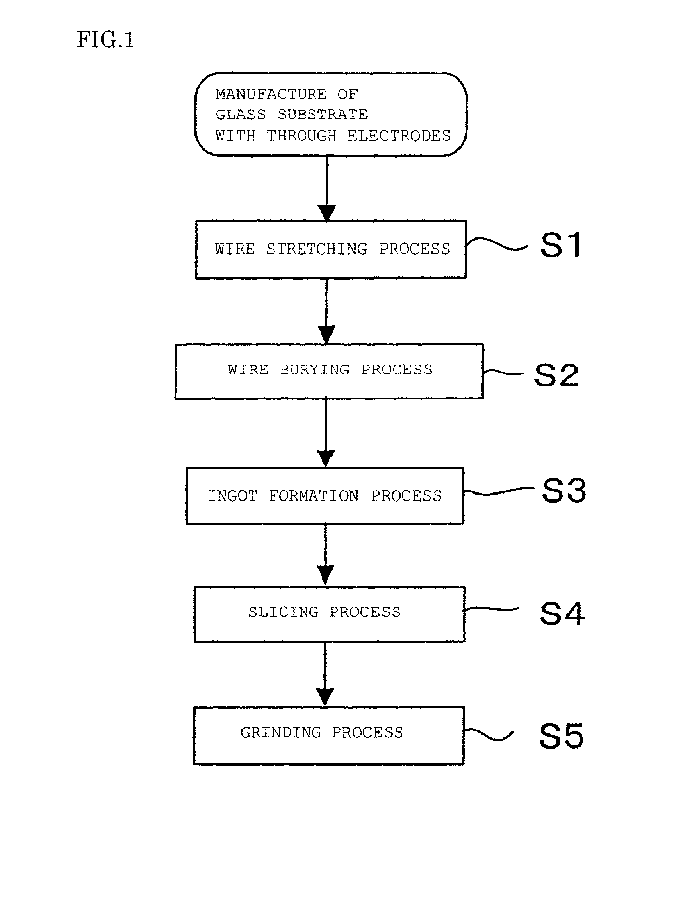

Fig. 1 is a flowchart illustrating a method of manufacturing a glass substrate with through electrodes according to an embodiment of the invention as a basic configuration of the invention. First, in the wire stretching process S1, a plurality of wires are stretched in parallel between two bases made of a heat-resistant material such as carbon. As a material of the wires, a material having a thermal expansion coefficient close to that of the glass substrate is selected. Then, in a wire burying process S2, the two bases having a plurality of stretched wires are placed into, for example, a heat-resistant container, and molten glass is placed into the container in a flowing form to bury a plurality of the wires in the glass. In this case, the glass is heated to a temperature of 1000°C or higher, and the molten glass is pressed as necessary to assist a flow of the glass. In addition, instead of placing both the bases having the stretched wires into the heat-resistant container, the container may be made from two bases having the stretched wires, and the glass may be placed into this container in a flowing form.

Then, in an ingot formation process S3, the glass is cooled to form a glass ingot. In the case where both the bases having stretched wires are placed into the container, the glass ingot is extracted from the container. In the case where the two bases form a container, the glass ingot is obtained by removing the base portions. Then, in a slicing process S4, the glass ingot is cut into round slices using a slicer such as a wire saw. Then, in a polishing process S6, both surfaces of the sliced glass panel are ground and polished to expose the cross sections of the wires on both surfaces of the glass panel so that a glass substrate with through electrodes is obtained. In this manner, a plurality of wires are tensioned, buried in molten glass, cooled, and sliced. Therefore, it is possible to obtain a glass substrate with through electrodes without bending.

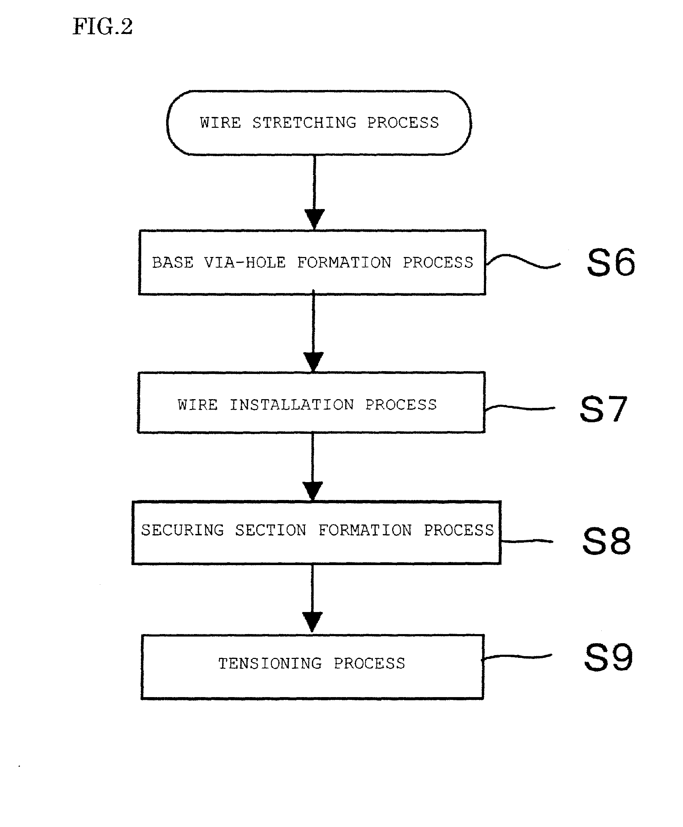

Fig. 2 is a flowchart illustrating another method of manufacturing a glass substrate with through electrodes according to an embodiment of the invention. A wire stretching process S1 includes a base via-hole formation process S6 in which a plurality of via-holes are formed in the two bases, a wire installation process S7 in which a plurality of wires are penetrated through a plurality of via-holes, and a securing section formation process S8 in which the securing section is formed in the leading end of the wire to secure one end of the penetrating wire in the base. In the wire installation process S7, for example, the two bases having the via-holes appropriately positioned are installed on a vibration plate. In addition, wires are prepared while jigs are provided in each end thereof. The jig has a diameter larger than that of the via-hole, and the wire has a diameter slightly smaller than that of the via-hole. The wire is loaded on two vibrating bases. As a result, even when a plurality of via-holes are provided in the base, the wires can be readily placed through the via-holes. In this case, the jig of the wire serves as a stopper.

Next, in a securing section formation process S8, the upper base is elevated, and the two jigs are separately fixed. In addition, a securing section is formed in a projection of the wire projected from the lower face of the lower base. Then, in the tensioning process S9, stress is applied to separate both bases away. That is, a plurality of installed wires are tensioned. As a result, it is possible to readily stretch a plurality of wires between two bases.

In an ingot formation process S3, a cooling rate from a temperature 50°C higher than the distortion point of the glass substrate to a temperature 50°C lower than the distortion point thereof can be configured to be slower than a cooling rate to a temperature 50°C higher than the distortion point thereof. As a result, distortion remaining in the glass substrate is reduced, it is possible to prevent a gap or a crack being generated between the wire and the glass substrate, and it is possible to form the through electrodes with a high hermetical sealing property. In addition, if the thermal expansion coefficient of the wire is approximately equal to that of the glass, the remaining stress caused by a difference of thermal expansion is reduced so that it is possible to prevent a gap or a crack between the through electrode and the glass. Hereinafter, embodiments of the invention will be described in detail with reference to the accompanying drawings.

### First Embodiment

Figs. 3 to 7B are explanatory diagrams illustrating a first embodiment of the invention. Fig. 3 illustrates a condition in which wires 2 are installed between an upper base 1a and a lower base 1b. Fig. 4 illustrates a condition in which the installed wires 2 are tensioned. Figs. 3 and 4 are provided to explain the wire stretching process S1.

Referring to Fig. 3, a plurality of via-holes (not shown) are formed in the upper and lower bases 1 a and 1b, and the wires 2 are penetrated through each via-hole. Referring to Fig. 4, an upper tensioning member 3a and a lower tensioning member 3b are installed in both ends or four directions of the upper and lower bases 1 a and 1 b having a plurality of stretched wires 2, and stress T is applied to separate the upper and lower bases away using a spring member 4. As a result, it is possible to tension a plurality of wires 2 between the upper and lower bases 1 a and 1 b. The upper and lower bases 1 a and 1 b are made of a carbon material or a ceramic material, and have the via-holes formed in the same positions on the plate surface. The upper and lower tensioning members 3a and 3b may also be formed of a carbon material or a ceramic material. The wires 2 may be formed of Fe-Ni alloy, for example, 42 alloy or Kovar. If such alloy is used, the thermal expansion coefficient can be approximated to glass, so that degradation in a surface between glass and wires with respect to a thermal variation can be reduced. The wire 2 may have a diameter of 0.05 to 1 mm, and the shortest distance between the wires 2 may be set to 0.5 to 2 mm. The diameters of the upper and lower bases 1 a and 1 b are set to 1 to 4 inches. The upper and lower bases 1 a and 1 b are made of carbon. In addition, the upper and lower bases 1 a and 1 b may be rectangular or polygonal.

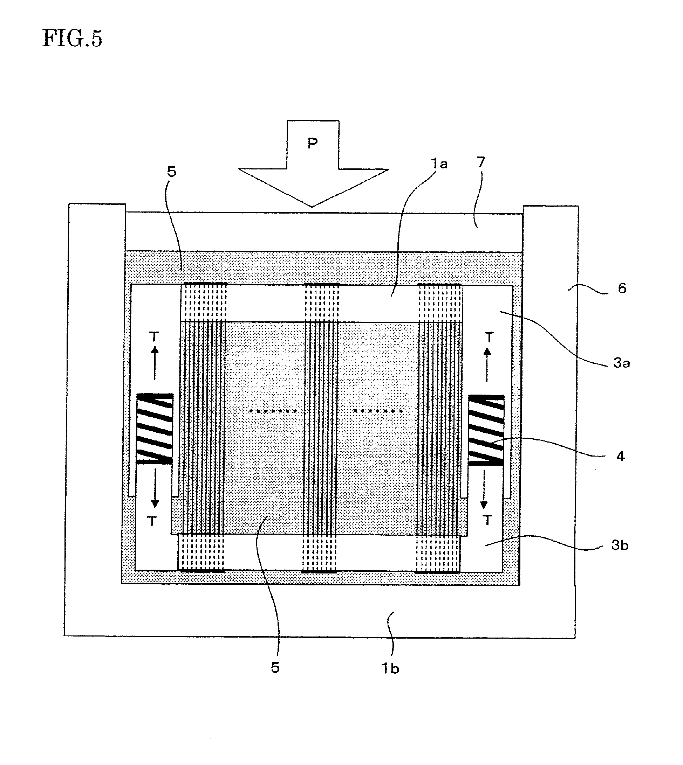

Fig. 5 is an explanatory diagram of the wire burying process S2, which shows a condition in which the upper and lower bases 1 a and 1b or the upper and lower tensioning members 3a and 3b are placed into the container 6. The wires 2, the upper and lower bases 1 a and 1b, and the upper and lower tensioning members 3a and 3b are housed in the heat-resistant container 6. Then, the container 6 is heated to a temperature of 1000°C or higher, and molten glass is placed from an upper opening so that the wires 2 are buried by the glass material 5. In addition, the floating of the glass material 5 can be expedited by covering a lid 7 on top of the container 6 and applying pressure P to the molten glass material 5. The glass material 5 may include soda-lime glass, borosilicate glass, lead glass, or the like. In Fig. 5, instead of using the heat-resistant container 6, the heat-resistant container and the lid thereof may be configured using the upper and lower bases, and a plurality of wires may be stretched between the upper and lower bases, so that molten glass may be placed into the upper and lower bases as a heat-resistant container. As a result, it is possible to reduce a consumption amount of glass or the containers.

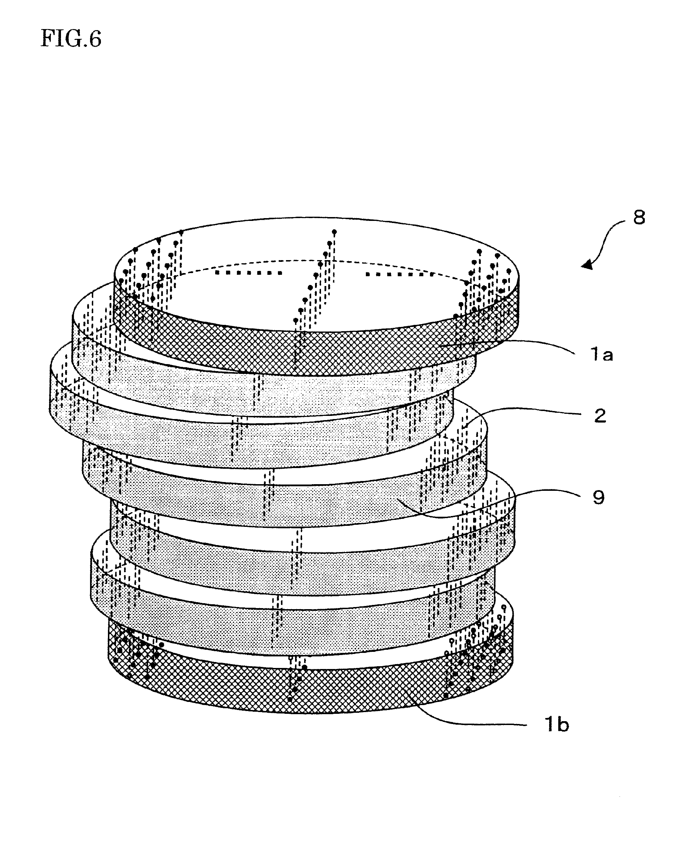

Fig. 6 is a diagram showing an ingot formation process S3 and a slicing process S4. The container 6 and the glass material 5 are cooled, and the upper and lower tensioning members 3a and 3b and the upper and lower bases 1 a and 1b are extracted from the container 6. By removing the upper and lower tensioning members 3a and 3b, a glass ingot is obtained. In addition, the glass ingot 8 is cut into round slices using a dicing saw or a wire saw to obtain a glass panel 9. Since the glass ingot 8 is sliced after cooling, the glass panel 9 obtained after the slicing has little bending. Then, in the grinding process S5, both surfaces of the glass panel 9 are ground and polished so that a glass substrate 11 with buried through electrodes 10 is obtained. It is possible to form the glass substrate 11 having excellent flatness since the surface of the through electrode 10 and the surface of the glass material are in parallel without a height difference.

In addition, in the ingot formation process S3, a cooling rate from a temperature 50°C higher than the distortion point of the glass substrate to a temperature 50°C lower than the distortion point thereof can be configured to be slower than a cooling rate to a temperature 50°C higher than the distortion point thereof. As a result, distortion remaining in the glass substrate is reduced, and it is possible to prevent a gap or a crack generated between the wires 2 and the glass panel 9 and to form through electrodes with a high hermetical sealing property.

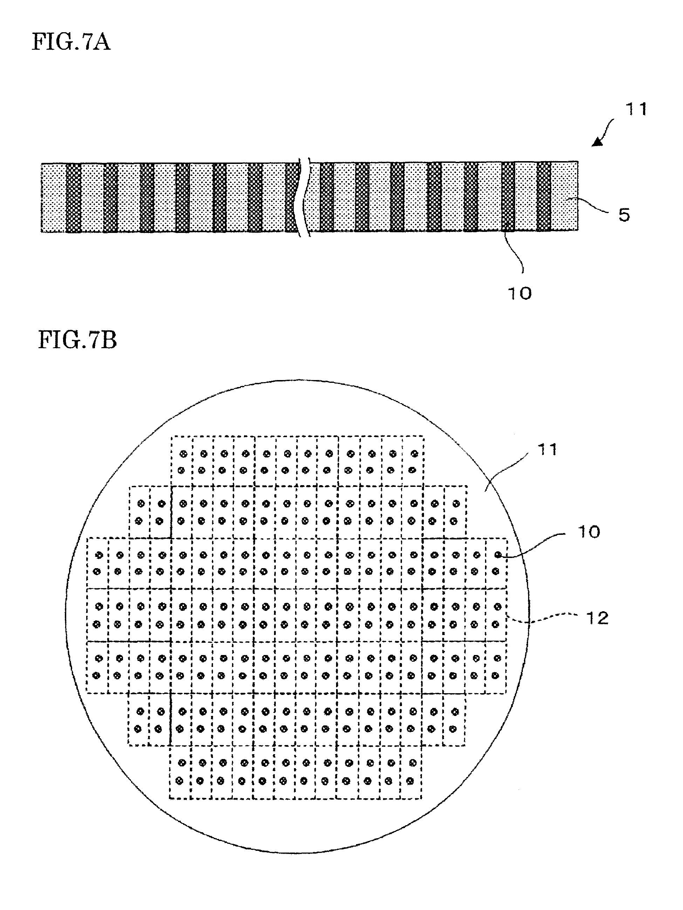

Fig. 7A is a schematic vertically cross-sectional view illustrating the glass substrate 11, and Fig. 7B is a schematic top view illustrating the glass substrate 11. Since the through electrodes 10 and the glass 5 are fused and bonded, a high hermetical sealing property is provided. Since the bending of the surface of the glass substrate 11 is insignificant, it is possible to perform grinding and polishing within a short period of time, and the grinding amount of the glass is also insignificant. As shown in Fig. 7B, a plurality of unit cells partitioned by a cutting line 12 are formed simultaneously, each with the two through electrodes 10.

### Second Embodiment

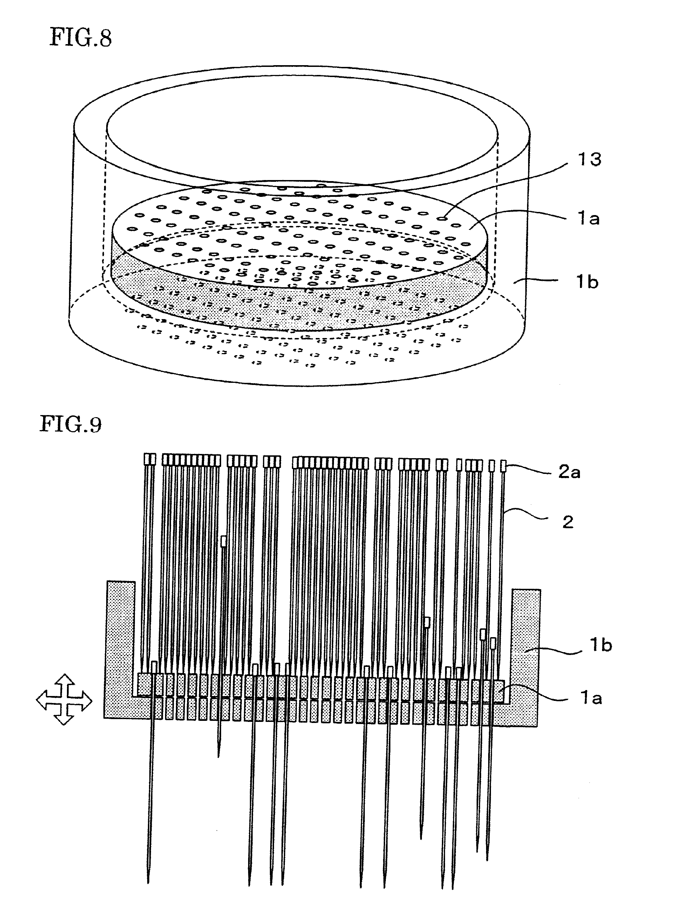

Figs. 8 to 11 are diagrams showing a method of manufacturing a glass substrate according to a second embodiment of the invention, and show a wire stretching process S1 in detail. Other processes are similar to those of the first embodiment, and description thereof will be omitted.

Fig. 8 illustrates a base via-hole formation process S6, in which a plurality of via-holes 13 are formed in a falling lid-shaped upper base 1a and a cylindrical-shaped lower base 1b, and in which the upper and lower bases 1a and 1b are stacked while positions of the via-holes of the upper and lower bases 1a and 1b are aligned. The upper and lower bases 1a and 1b may be formed of a carbon material or a ceramic material. The via-holes 13 may be punctured using a diamond drill or the like. Alternatively, the via-holes may be previously formed in a green sheet, which may be sintered so as to provide a base with the via-holes. In addition, while the upper and lower bases 1a and 1b are disc-shaped or cylindrical-shaped, the invention is not limited thereto.

Fig. 9 illustrates a wire installation process S7 in which the wires 2 are installed in the upper and lower bases 1a and 1b. First, the wires 2 are prepared such that one end is provided with a jig 2a having a diameter larger than that of the wire 2, and the other end is needle-shaped. The jig 2a has a diameter larger than that of the via-hole 13 provided in the upper and lower bases 1a and 1b, and the wire 2 has a diameter slightly smaller than that of the via-hole 13. Then, the upper base 1a falls down into the inner side of the lower base 1b, and the positions of the via-holes 13 of the upper and lower bases 1a and 1b are aligned. Then, a plurality of wires 2 having the jigs 2a are vertically placed onto the upper base 1a housed in the lower base 1b while the sharp leading ends are directed downward. In addition, the lower base 1a is placed in the vibration generator (not shown) and vibrated from right to left and up and down. As a result, the wires 2 can be placed and seated in a plurality of via-holes 13 within a short period of time.

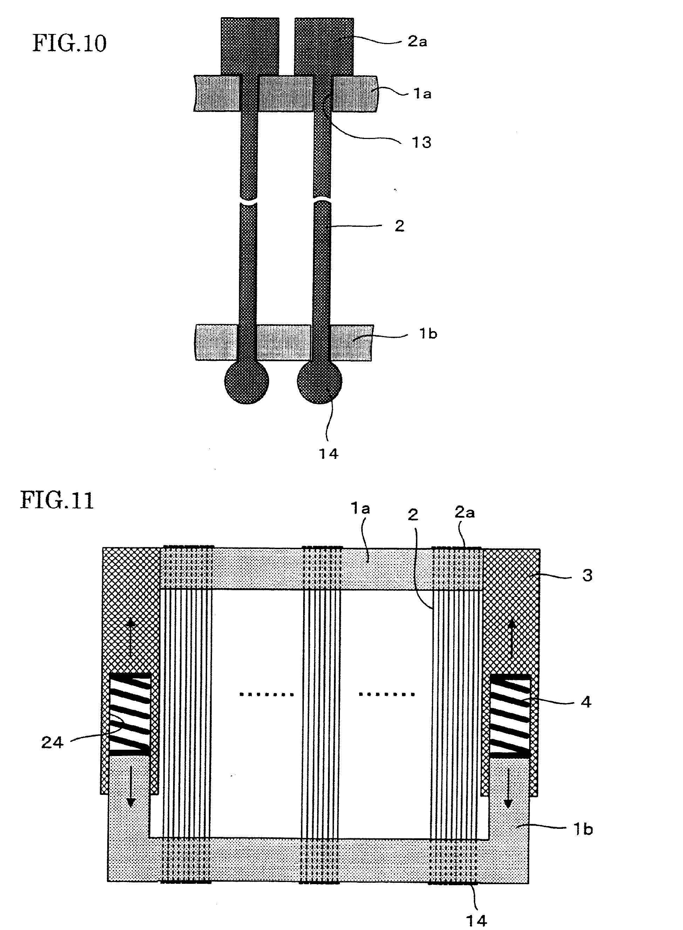

Fig. 10 illustrates a securing section formation process S8 in which the upper base 1a is lifted to be separated from the bottom of the lower base 1b, and the securing section 14 is formed in the leading end of the wire 2 projected from the rear surface of the lower base 1b. Since the diameter of the jig 2a is larger than that of the via-hole 13, the wires 2 are elevated by lifting the upper base 1a. In addition, after the upper base 1a is lifted by the length of the glass ingot 8, the leading end of the wire 2 is molten so that a securing section 14 having a diameter larger than that of the via-hole 13 is formed. As a result, a plurality of wires 2 are tensioned by applying a stress T in an expanding direction of the upper and lower bases 1a and 1b. Alternatively, since the securing section 14 is used to secure the wire 2 in the lower base 1b, the securing section 14 may be formed to prevent the wire 2 from being removed out of the lower base 1b by tying or bending a part of the wire 2 projected to the rear surface side from the lower base 1b instead of melting the leading end of the wire 2.

Fig. 11 illustrates a tensioning process S9 for tensioning the wires 2. The outer circumference of the upper base 1a is fixed, and a housing 24 is formed to house the upper end of the cylinder of the lower base 1b. The tensioning member 3 biasing the upper and lower bases 1a and 1b to be separated away from each other is provided by integrating a spring member 4 with the housing 24. A glass material introduction hole (not shown) is included in the side surface of the tensioning member 3 in the vicinity of the upper base 1 a to allow molten glass to be charged into the internal space obtained by the upper and lower bases 1 a and 1b and the tensioning member 3. Using such a configuration, it is possible to use a glass material with economy.

### Third Embodiment

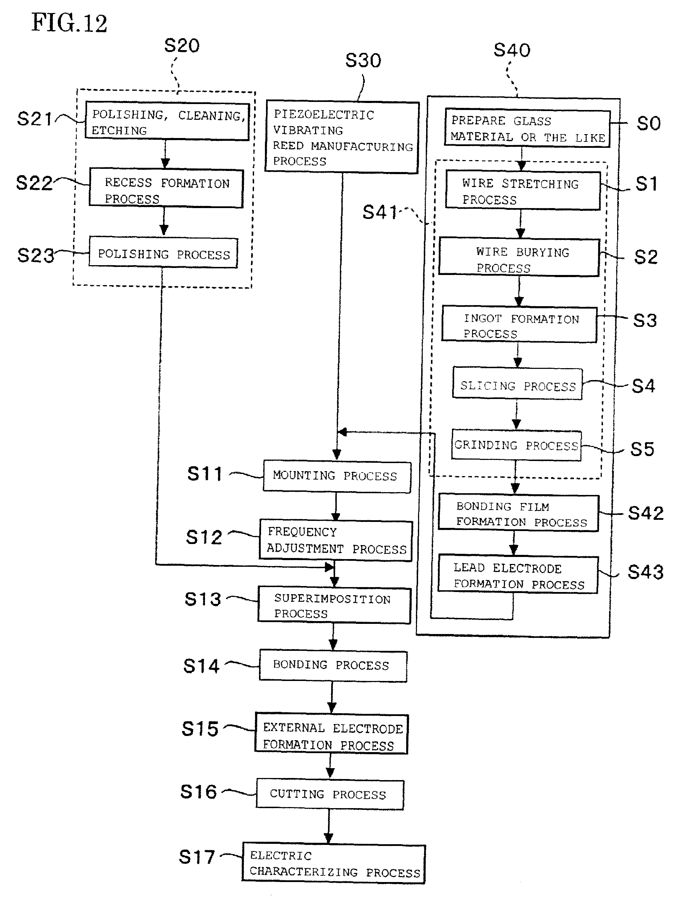

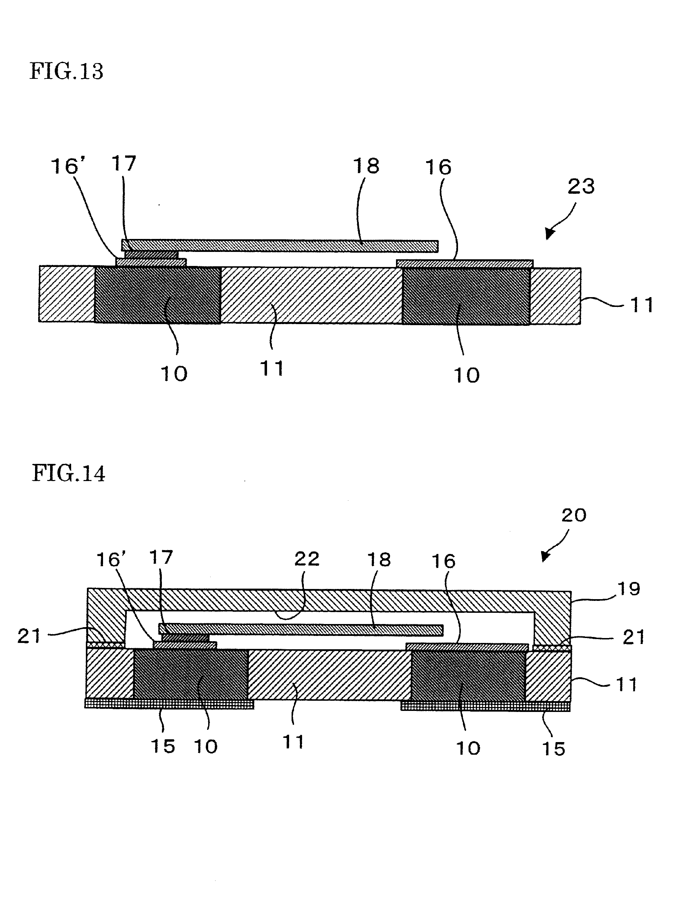

Fig. 12 is a flowchart illustrating a method of manufacturing an electronic component according to a third embodiment of the invention. Fig. 12 also shows an example in which a piezoelectric vibrator is used as an electronic component for mounting the glass substrate. Fig. 13 is a schematic cross-sectional view illustrating a condition in which a piezoelectric vibrating reed 18 is mounted on the glass substrate 11 having the through electrodes 10. Fig. 14 is a schematic cross-sectional view illustrating a completed piezoelectric vibrator 20. In the third embodiment, a base substrate formation process S40, a lid substrate formation process S20, and a piezoelectric vibrating reed formation process S30 are provided. Hereinafter, these processes are described in sequence.

First, in a preparation process S0 for preparing a glass material or the like, a glass material for forming the glass substrate 11, wires 2 for forming the through electrodes 10, and the like are prepared. In a wire stretching process S1, a plurality of via-holes are formed in the upper and lower bases 1 a and 1b, and a plurality of wires 2 made of a conductive material are stretched through the via-holes. Then, in a wire burying process S2, molten glass is injected in a flowing form into the wires between the upper and lower bases 1 a and 1 b so as to bury the wires 2 in the glass. Then, in an ingot formation process S3, the glass is cooled, and the glass ingot 8 having the buried wires 2 is extracted. Then, in a slicing process S4, the glass ingot 8 is cut into round slices to form the glass panel 9. Then, in a grinding process S5, both surfaces of the sliced glass panel 9 are polished to expose the wires 2 on the front and rear surfaces thereof as the through electrodes 10. This is the glass substrate formation process S41.

Then, in a bonding film formation process S42, a bonding film for positive electrode bonding is deposited on the area corresponding to the vicinity of the glass substrate 11 or unit cell. As the bonding film, an aluminum film is deposited. Then, in a lead electrode formation process S43, a lead electrode 16 is formed alongside the outer circumference of the glass substrate 11 or unit cell from the top surface of one through electrode 10 to provide a base substrate 23. The lead electrodes 16 and 16' are formed by depositing an Au/Cr film using a sputtering method, and patterned by performing photolithography and etching. The lead electrodes 16 and 16' may be formed through a printing method or the like instead of the sputtering method. This is the base substrate formation process S40.

Next, a lid substrate formation process S20 will be described. The lid substrate 19 is preferably formed of the same material as that of the base substrate 23 in order to reduce a thermal expansion difference when the lid substrate 19 is bonded to the base substrate 23. When soda-lime glass is used in the base substrate 23, the lid substrate 19 is also formed of soda-lime glass. First, in the polishing, cleaning, and etching process S21, the glass substrate is polished and etched to remove a process-deformed layer on the outermost surface, and then cleaned.

Then, in a recess formation process S22, the recess 22 is formed through press-molding. The recess 22 is formed by interposing the glass substrate between a receiving template having a convex ridge and a press template having a recess and heating and press-molding it at a temperature equal to or higher than a softening point of the glass material. The molding template is preferably formed of a carbon material since it facilitates release of glass and provides excellent absorption of foams. Then, in a polishing process S23, the bonding surface to the base substrate 23 is polished to provide a flat surface. As a result, it is possible to improve a hermetical sealing property when bonded to the base substrate 23.

Then, in a piezoelectric vibrating reed formation process S30, a piezoelectric vibrating reed 18 made of a crystal panel is prepared. Excitation electrodes (not shown) electrically disconnected from each other are formed on both surfaces of the piezoelectric vibrating reed 18, and electrically connected to a terminal electrode formed on one surface of the piezoelectric vibrating reed 18. Then, in a mounting process S11, a conductive adhesive 17, for example, a gold bump is formed in the through electrode 10 of the base substrate 23 and the end portion of the lead electrode 16' or the terminal electrode of the piezoelectric vibrating reed 18. Using such a conductive adhesive 17, the piezoelectric vibrating reed 18 is mounted in a cantilever beam shape. As a result, the excitation electrodes formed on both surfaces of the piezoelectric vibrating reed 18 are electrically disconnected from each other and conductively connected to the two through electrodes 10.

Then, in a frequency adjustment process S12, a vibration frequency of the piezoelectric vibrating reed 18 is adjusted to a predetermined frequency. Then, in a superimposition process S13, the lid substrate 19 is placed on the base substrate 23 and superimposed using a bonding material 21. Then, in a bonding process S14, the base substrate 23 and the lid substrate 19 that are superimposed are heated, and a high voltage is applied between the base substrate 23 and the lid substrate 19 so as to be anodically bonded. Then, in an external electrode formation process S15, external electrodes 15 electrically connected to each of the through electrodes 10 are formed on the outer surface of the base substrate 23. Then, in a cutting process S16, the glass substrate is cut alongside the cutting line to obtain individual piezoelectric vibrators 20.

In this manner, a plurality of wires 2 are stretched between the upper and lower bases 1 a and 1 b, the molten glass is injected in a flowing form to the wires and cooled to form the glass ingot 8, and then the glass ingot 8 is sliced and polished to manufacture the glass substrate 11. Using such a glass substrate 11, it is possible to form through electrodes 10 with a high hermetical sealing property and a high positioning precision and provide excellent flatness. Therefore, it is possible to maintain a hermetical sealing property between the base substrate 23 and the lid substrate 19. As a result, it is possible to provide a piezoelectric vibrator 20 with high reliability. In addition, the external electrode 15 formed in the external electrode formation process S15 according to the aforementioned embodiment may be previously formed in the glass substrate formation process S40. In addition, the frequency adjustment process S12 may be preceded by the cutting process S16.

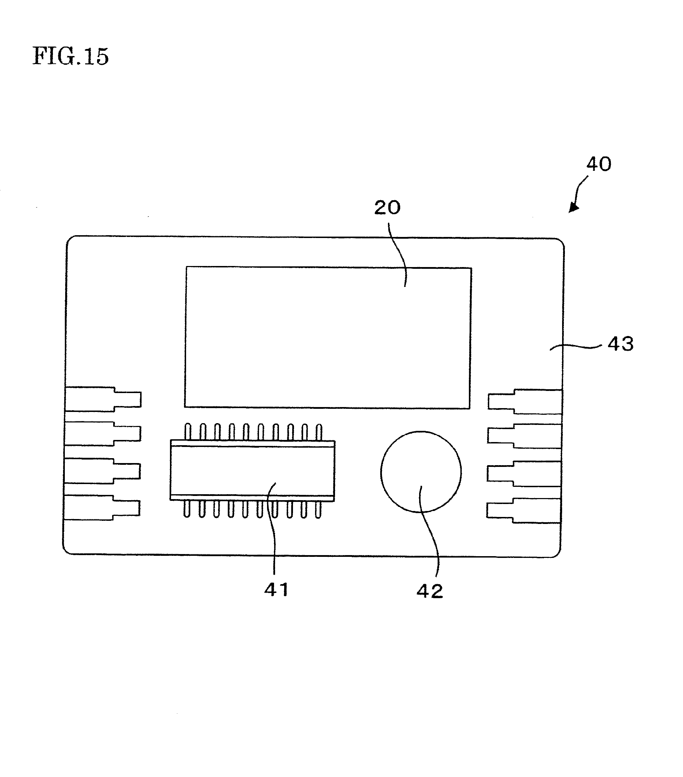

Fig. 15 is a schematic top view illustrating an oscillator 40 obtained by integrating the piezoelectric vibrator 20 manufactured through the manufacturing process described in the third embodiment. As shown in Fig. 15, the oscillator 40 includes a board 43, a piezoelectric vibrator 20 provided on the board, an integrated circuit 41, and an electronic component 42. The piezoelectric vibrator 20 generates a predetermined frequency signal based on the driving signal applied to the external electrodes 6 and 7. The integrated circuit 41 and the electronic component 42 process the predetermined frequency signal supplied from the piezoelectric vibrator 20 to generate a reference signal such as a clock signal. Since the piezoelectric vibrator 20 according to an embodiment of the invention can be miniaturized with high reliability, the entire oscillator 40 can be configured more compactly.

The foregoing description has been given by way of example only and it will be appreciated by a person skilled in the art that modifications can be made without departing from the scope of the present invention.

## Claims

1. A method of manufacturing a glass substrate (11) with through electrodes (10), the method comprising:
a wire stretching process (S1) in which a plurality of conductive wires (2) are stretched in parallel between two bases (1a, 1b);
a wire burying process (S2) in which a plurality of the wires between the bases are buried by glass;
an ingot formation process (S3) in which a glass ingot (8) having the buried wires is formed by cooling the glass;
a slicing process (S4) in which a glass panel (9) is formed by slicing the ingot; and
a polishing process (S5) in which a plurality of the wires are exposed on front and rear surfaces by polishing the glass panel to provide the through electrode.

2. The method according to claim 1, wherein the wire stretching process includes
a via-hole formation process (S6) in which a plurality of via-holes are formed in the two bases,
a wire installation process (S7) in which a plurality of the wires are penetrated through a plurality of via-hoes,
a securing section formation process (S8) in which a securing section (14) for securing one end of the wire in the base is formed, and
a tensioning process (S9) in which the wires are tensioned.

3. The method according to claim 1 or 2, wherein in the ingot formation process, a cooling rate from a temperature 50°C higher than the distortion point of the glass substrate to a temperature 50°C lower than the distortion point thereof is configured to be slower than a cooling rate to a temperature 50°C higher than the distortion point thereof.

4. The method according to any one of claims 1 to 3, wherein a thermal expansion coefficient of the wire is substantially equal to that of the glass.

5. A method of manufacturing an electronic component, the method comprising:
a base substrate formation process in which the glass substrate is formed based on the method of manufacturing the glass substrate with through electrodes according to any one of claims 1 to 4, and an electrode is formed in the glass substrate to provide a base substrate;
a mounting process in which an electronic component (18) is mounted on the base substrate; and
a bonding process in which a lid substrate (19) is bonded to the base substrate (23) having the mounted electronic component.
